(19)

Europäisches
Patentamt
European
Patent Office
Office européen
des brevets

(11) **EP 3 825 873 A1**

(12) **EUROPEAN PATENT APPLICATION**

(43) Date of publication:
26.05.2021 Bulletin 2021/21

(21) Application number: 20207575.0

(22) Date of filing: 13.11.2020

(51) Int Cl.:
*G06F 16/9035* (2019.01)     *G06N 20/00* (2019.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME
KH MA MD TN**

(30) Priority: **15.11.2019 TR 201917869**

(71) Applicant: **Commencis Teknoloji A.S.
03400 Istanbul (TR)**

(72) Inventors:
• **ISBECER, FATIH
Istanbul (TR)**
• **PEKIN, SAIT ALP
03400 Istanbul (TR)**

(74) Representative: **Sevinç, Cenk
Grup Ofis Marka Patent A.S.
Ataturk Bulvari 211/11
Kavaklidere
06680 Ankara (TR)**

(54) **SYSTEM WITH BIG DATA ANALYSIS DEVICE FOR CLOUD PLATFORMS AND THE OPERATION METHOD THEREOF**

(57)     The present invention relates to a system comprising a big data analysis device and a method for operating said device, wherein said big data analysis device is capable of analyzing data used by big data processing software before transferring data to a cloud platform and transferring the pertinent data to storage spaces of cloud systems. The present invention particularly relates to a system comprising a big data analysis device and a method for operating said device wherein said big data analysis device is capable of performing processes such as organizing and classifying big data according to predetermined algorithms and software and is further capable of performing processes such as cleansing, compressing and encrypting big data before transferring it to cloud platforms.

EP 3 825 873 A1

**Description**

**Technical Field of the Invention**

The present invention relates to a big data analysis device that analyzes the data used by big data processing software before transferring data to a cloud platform and that subsequently transfers the pertinent data to storage spaces of cloud systems.

The present invention particularly relates to a big data analysis device that is capable of performing processes such as organizing and classifying big data according to predetermined algorithms and software and that is further capable of performing processes such as cleansing, compressing, and encrypting big data before transferring it to cloud platforms.

**State of the Art**

Big data is defined as an enormous cumulation of data stack in which various works performed by people, social media accounts used on a daily basis, search engines, traces they left behind while surfing the Internet and single users' all types of interactions with the internet are gathered. The term big data has begun to be used for the Internet and quickly became a concept that gets involved in our daily lives and to which we continuously contribute.

A lot of data is stored, processed, and managed as computers make their presence felt in every aspect of our lives. The circulation, processing, and rapid replication of this data in the electronic environment bear another consequence as the Internet is so widely utilized by companies, organizations, and people. The aforementioned cumulative big data not only comprises data that is input as required and stored by a service, but also contains large quantities of data which appears to be completely redundant and useless, and this type of data keeps snowballing and accordingly get accumulated at a great pace.

Therefore, this type of data needs to be processed and cleansed from the redundant portions thereof and accordingly filtered to obtain the useful data. There is a number of applications developed for that specific purpose. Sifting through the redundant data plays a vital role particularly in transferring big data to cloud platforms. Transferring big data to cloud platforms requires a strong infrastructure as well as a fast connection. Nowadays, the big data is usually transferred to a cloud platform or a similar database and subsequently filtered and sifted through in the process of removing redundant data from big data.

The patent document numbered **"2016/14041"** has been examined as a result of the preliminary search conducted in the state of the art. The abstract of said patent document discloses; "The present invention relates to a smart street lighting system that is based upon big data analysis and IoT sensors and a method for lighting streets based on said system, wherein the smart street lighting system is based on the assessment performed by the big data analysis unit that determines the lighting rates of street lamps by means of evaluating the data to be obtained from IoT sensors integrated into street lights. The central processing unit conducts an assessment on both the data transmitted from IoT sensors and the data transmitted from the big data analysis unit, adjusts the on/off states of street lights as well as the intensity of the light to be emitted and sends a command to the control unit. The operating interface conveys the evaluations, expectations, and suggestions of people to the big data analysis unit, and ensures that the system operators are notified regarding the alarm states communicated by the big data analysis unit."

The patent document numbered **"US2014336791"** has been examined as a result of the preliminary search conducted in the state of the art. The invention disclosed in said application relates to a system utilized for gathering data from a plurality of industrial for storing and analysis purposes in a cloud platform. Said invention is capable of filtering, classifying, and encrypting data. Various functions and algorithms are utilized for performing such processes.

The patent document numbered KR101831959 has been examined as a result of the preliminary search conducted in the state of the art. The invention disclosed in said patent application relates to a cloud service system providing a big data analysis module. The inventive system comprises; a plurality of cloud local servers providing the big data analysis module, and performing a big data analysis with respect to cloud data; and a central big data analysis server performing a central big data analysis based on big data analysis data received from the cloud local servers, and providing an analyzed result to the cloud local servers.

In the state of the art, systems used for processing big data transfer the data from the data source directly to cloud systems, and analysis and processing operations are performed in a cloud environment. This results in redundant snowballing in the amount of data present in the cloud environment, thereby causing inefficiency in both storing and processing operations. The amount of redundant data not only increases the costs for data hosting but also results in overconsumption of resources since the duration of processing increases.

Consequently, the aforementioned disadvantages existing in the state of the art and the inadequacies of available solutions necessitated making an improvement in the relevant technical field.

## Objects of the Invention

The most important object of the present invention is to implement methods such as classifying, filtering, and encrypting data prior to transferring the gathered ERP (Enterprise Resource Planning), CRM (Customer Relationship Management), and mobile and web application user data to the cloud system, thereby providing various advantages including cost, speed, and memory efficiency to cloud systems.

Another object of the present invention is to ensure that respective data may be classified by sorting the filtered data and performing the necessary tagging operation.

Another object of the present invention is to ensure that corporation-specific security rules may be applied when the inventive device is operated as a part of the corporate network, so that the respective data may be transferred to the cloud environment by being encrypted. Thus, the security level may be increased.

Yet another object of the present invention is to ensure that the transferred data may be rendered into data packages by being subjected to data compression algorithms. Thus, the data transfer rate is increased, thereby providing efficiency.

Yet another object of the present invention is to ensure that multi-feature data may be filtered and classified fast and with high accuracy by using Artificial Neural Networks (ANN), and Multilayer Perceptron (MLP) algorithms.

Yet another object of the present invention is to provide memory and speed advantages by the used methods while preserving the principle of maximizing the accuracy rate and the number of features.

Yet another object of the present invention is to maximize the accuracy of the algorithm referred to as "accuracy" through performing filtering and classifying operations by using artificial intelligence algorithms on the big data. Thus, it is ensured that artificial neural network methods may be used, and the algorithm may be trained with enough sample data since the accuracy rate is high.

Yet another object of the present invention is to ensure that data classification may be performed both faster and in a more accurate manner on a trained artificial neural network since artificial neural network methods are utilized.

Structural and characteristic features of the present invention, as well as all advantages thereof, will become clear through the attached figures and the following detailed description provided by making references thereto. Therefore, the necessary assessment should be performed in view of the attached figures and the detailed description provided herein.

## Description of the Figures

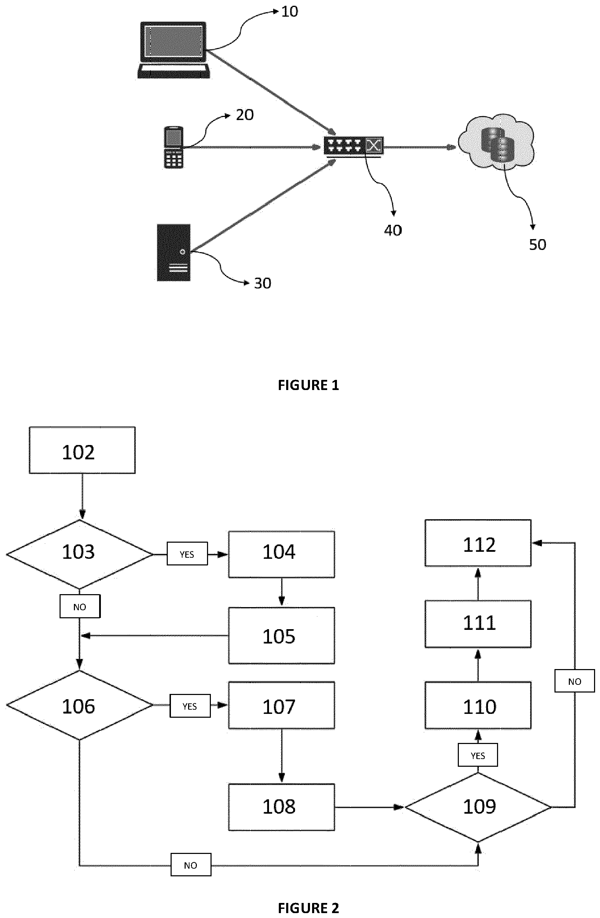

**FIGURE** 1     illustrates the schematic view of the mode of operation of the inventive system.

**FIGURE 2**     illustrates the flow chart of the operating method and operations to be performed in the inventive system.

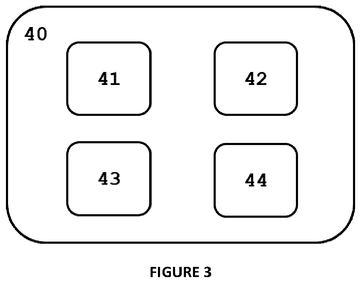

**FIGURE 3**     illustrates the schematic view of the data device of the inventive system.

## Reference Numerals

**10.** Computer Data Sources
**20.** Mobile Device Data Sources
**30.** Server Data Sources
**40.** Data Analysis Device
**41.** Filtering Unit
**42.** Classifying Unit
**43.** Compression Unit
**44.** Encryption Unit
**50.** Cloud System
**102.** Receiving Data from Data Sources
**103.** Performing Filter Algorithm Control for Data
**104.** Executing the Filter Algorithm
**105.** Filtering and Tagging Pertinent Data
**106.** Performing Compression Algorithm Control for Data
**107.** Executing the Compression Algorithm

**108.** Transmitting the Compressed Data
**109.** Performing Encryption Algorithm Control for Data
**110.** Executing the Encryption Algorithm
**111.** Transmitting the Encrypted Data
**112.** Transmitting the Data to the Cloud System

## Description of the Invention

Data analysis device (40) of the inventive system allows for performing various operations, including classifying, filtering, and encrypting on ERP (Enterprise Resource Planning), CRM (Customer Relationship Management) data received from computer data sources (10), mobile device data sources (20) and server data sources (30), and transferring said data to the cloud system (50) after said operations are performed. Thus, the present invention provides numerous advantages in terms of costs, speed, and memory.

The data to be used in big data reach the inventive data analysis device (40) prior to being transferred to the cloud system (50). The software run by the processors of the data analysis device (40) allows for subjecting data having a data structure desired to be used, to a filtering operation within the received data. The processing of non-pertinent data begins as it comes from the source, thereby redundant data is prevented from being transmitted to the cloud system (5). This operation may be managed effectively when it is performed from a single point for lots of data received from a plurality of sources. Thus, the need for performing any operational processes for the data organization on computer data sources (10), mobile device data sources (20), and server data sources (30) becomes unnecessary.

Filtered data may be subjected to a sorting operation by means of the data analysis device (40) if necessary, and accordingly, data may be sorted by performing the respective tagging operation.

As the data analysis device (40) may be operated as a part of a corporate network, corporation-specific security rules may be applied, and the pertinent data may be transferred to the cloud system (50) by being encrypted if desired. Thus, a user-specific security level may be determined, thereby increasing the present security level.

The inventive data analysis device (40) has an operating method. Accordingly, the operating method of the inventive data analysis device (40) comprises the following process steps. Initially, data is received from the data sources (102), wherein said data sources are computer data sources (10), mobile device data sources (20), and server data sources (30). The filter algorithm is subjected to a control operation (103) for data by the filtering unit (41) and subsequently, the filter algorithm is executed (104). The purpose of this step is to check whether there is a predetermined filtering operation or not. In case there is a predetermined filtering operation, the filter algorithm is executed (104) by the filtering unit (41), and in case there is not, the system proceeds to the next step. Pertinent data are filtered and tagged (105) upon the running of the filtering unit (41). Subsequently, the compression algorithm is subjected to a control operation (106) for data by the compression unit (43), and the compression algorithm is executed (107). This step is performed by the compression unit (43) to check whether there is a predetermined compression operation, or not. In case a compression operation has been specified by the user, a compression algorithm is executed (107), in case there is not, then the system proceeds to the next step. The pertinent data is transmitted (108) by the compression unit (43) if a compression operation has been performed. Subsequently, an encryption algorithm control operation is performed (109) for the data compressed by the encryption unit (44), and the encryption algorithm is executed (110). This step is performed by the encryption unit (44) to determine whether there is a predetermined compression operation, or not. In case there is an encryption operation, encrypted data is gathered by the encryption unit (44) to be transmitted (111), and in case there is no encryption operation, the pertinent data is sent directly to the cloud system (50) by the encryption unit (44). The data is collected for transmitting encrypted data (111) and subsequently, the pertinent data is transmitted (112) to the cloud system.

Fundamentally, the inventive data analysis device (40) allows for filtering the received data by means of the filtering unit (41), classifying the data by means of the classifying unit (42), compressing the data by means of the compression unit (43), and encrypting the data by means of the encryption unit (44). Algorithms and equations used by filtering unit (41), classifying unit (42), compression unit (43), and encryption (44) which are used for performing the aforementioned operations, are provided below.

Filtering unit (41) and classifying unit (42) utilize Artificial Neural Network and Multilayer Perceptron algorithms during the filtering and classifying processes of data. To elaborate the single-layer perceptron for explaining the respective algorithm more precisely;

$$Y = w(1)^*x(1) + w(2)^*x(2) + w(3)^*x(3) + \ldots + w(n)^*x(n) + w(0) \qquad (1)$$

Equation-1 used herein may be considered as a Simple Linear Regression. Initially, required classifications are determined for the problem defined by the user. For example, considering a problem classified according to the spending habits of the customers of a company, there may be a plurality of features specifying the spending habits of customers. Level of income, amounts they are willing to pay, fields they are interested in, etc. These features are defined as the X sequence (x1, x2, x3, ...). Subsequently, the target output groups (e.g. the group that spends on technology, or the group that spends on cosmetics, etc.) are determined. These are designated as the Y sequence (output groups). In view of the Simple Linear Regression model, a regression model must be available to define each output group. Accordingly, the models of Equation-1 will be as follows.

$$Y1 = w1(1)^*x(1) + w1(2)^*x(2) + w1(3)^*x(3) + … + w1(n)^*x(n) + w1(0)$$

$$Y2 = w2(1)^*x(1) + w2(2)^*x(2) + w2(3)^*x(3) + … + w2(n)^*x(n) + w2(0)$$

$$Y3 = w3(1)^*x(1) + w3(2)^*x(2) + w3(3)^*x(3) + … + w3(n)^*x(n) + w3(0)$$

W and w(0) values, which ensure the equilibrium of Equation-2 specific to each output group, are necessary in order to obtain the aforementioned models. Herein, W denotes the X vectors. The product of these vectors may be defined as w1(1)*x(1) + w1(2)*x(2) + w1(3)*x(3) + .... w(0) is denoted as the "noise" error margin/term.

$$Y = W^*X + w(0) \qquad (2)$$

To this end, a specific amount of data designated as a manually classified (divided into output groups) training set is used for training the model. Initially, W and w(0) values are randomly assigned for each output group for the training algorithm. Subsequently, Equation-2 is subjected to a sigmoid function for each output group.

The sigmoid function provides a value between 0 and 1. And this is used as a type of probability score. Namely, this may be considered as the input group's probability of corresponding to the output group. This probability is defined as predicted (Y_Predicted). The state in which the respective input group actually corresponds to the respective output group is defined as the truth (Y_Truth). Manual classification is actually the aforementioned truth (Y_Truth) value. For example, if the respective input group corresponds to the output group no. 2, then the respective relation is; Y(2)_Truth = 1, Y(1)_Truth = 0, Y(3)_Truth = 0 ....

The difference between the truth value and the predicted value (i.e. Y_Truth - Y_Predicted) gives the error value. In other words, in an ideal model, the sigmoid values are expected to give a value as approximate to the truth value (Y_Truth) as possible. Since the aim in the rest of the algorithm is to obtain W and w(0) values that would reduce the error to 0, W_gradient and w(0)_gradient values are obtained by deriving the error value relative to W and w(0) values and by multiplying it by a constant suitable for the problem. Obtained values are the update values used for approximating W and w(0) values to ideal. These values are added to present W and w(0) values and the operation is repeated until the error value is reduced to a certain level. Method of operation of the respective operations performed herein comprises the following process steps;

- Assigning W and w(0) values randomly,
- Calculating W_gradient and w(0)_gradient values,
- Updating W and w(0) values,
- Returning to the step of calculating W_gradient and w(0)_gradient values if the error margin is above a specific value.

Contrary to the single-layer example, the Multilayer Perceptron model consists of X (input layer), Z (intermediate layer), and Y (output layer). Here, the Z layer is created through the X layer, and the Y layer is created through the Z layer by means of performing the aforementioned operations. This may be considered as disclosed below;

Big data to be used is subjected to processing after training the respective model. As a result of the respective operations, each data sample possesses the aforementioned predicted values (Y_Predicted) for each output group. The data sample is classified as a member of the output group having the highest predicted value (Y_Predicted). Only the corresponding members of the respective groups are transferred to the cloud system (50) depending on the determined problem. Thus, the data of other groups are prevented from needlessly occupying storage spaces and causing time loss.

Data groups subjected to filtering and classifying operations by the filtering unit (41) and the classifying unit (42) also undergo compression operations performed by the compression unit (43) if and when necessary. To that end, the compression algorithm is executed (107), thereby compressing the respective data. Said compression unit (43) utilizes Dimensionality Reduction algorithms. If the data groups possess an n number of features, the number of these features are reduced to a D number of features (D is a number much smaller than N). To that end, selection and extraction methods are implemented based on the correlations between the problems and the features.

Selection a relatively less used method, wherein a D number of features are selected among an N number of features based on an order of priority. Extraction allows for creating new features from available features. For example, in the case of a data group with a, b, c, and d features, an "e" feature is created by combining a and b features having high correlation, wherein said "e" feature is affected by both a and b features. When this particular method is implemented for data having a plurality of features, it provides saving storage spaces up to 6-7 folds.

**Claims**

1.  Big data analysis system that analyzes the big data obtained from various sources prior to transferring said data to a cloud system (50), **characterized in that;** it comprises a data analysis device (40) that begins processing big data as they come from various sources, and that prevents redundant data from being sent to the cloud system (50), wherein said data analysis device comprises; a filtering unit (41) that filters the big data received from computer data sources (10), mobile device data sources (20), and server data sources (30), a classifying unit (42) that classifies the big data received from said sources, a compression unit (43) that compresses the big data received from said sources, and an encryption unit (44) that encrypts the big data received from said sources by means of the processors integrated thereto prior to transferring said big data to a cloud system (50).

2.  Big data analysis system according to Claim 1, **characterized in that;** method of operating of the data analysis device (40) comprises the process steps of;

    • Receiving (102) big data from computer data sources (10), mobile device data sources (20), and server data sources (30),
    • Subjecting (103) filter algorithm to a control operation for data by the filtering unit (41),
    • Executing (104) the filter algorithm by means of the filtering unit (41),
    • Filtering and tagging (105) pertinent data upon running the filtering unit (41),
    • Subjecting (106) the compression algorithm to a control operation for data by the compression unit (43),
    • Executing (107) the compression algorithm by means of the compression unit (43),
    • Transmitting (108) the data compressed by the compression unit (43) if a compression operation is performed,
    • Performing (109) an encryption algorithm control operation by means of the encryption unit (44) for the compressed data,
    • Executing (110) the encryption algorithm by means of the encryption unit (44),
    • Transmitting (112) the data to the cloud system.

3.  Big data analysis system according to Claim 2, **characterized in that;** the process step of subjecting (103) the filter algorithm to a control operation for data by means of the filtering unit (41) in the operating method of the data analysis device (40) further comprises the process steps of;

    - Executing (104) the filter algorithm by means of the filtering unit (41) in case there is a predetermined filtering operation,
    - Proceeding to the process step of subjecting (106) the compression algorithm to a control operation for data in case there is no predetermined filtering operation.

4.  Big data analysis system according to Claim 2, **characterized in that;** the process step of subjecting (106) the compression algorithm to a control operation for data by means of the compression unit (43) in the operating method of the data analysis device (40) further comprises the process steps of;

    - Executing (107) the compression algorithm in case a data compression operation is specified by the user,
    - Proceeding to the process step of performing (109) an encryption algorithm control operation by means of the encryption unit (44) for the compressed data.

5.  Big data analysis system according to Claim 2, **characterized in that;** the process step of performing (109) an encryption algorithm control operation by means of the encryption unit (44) for the compressed data in the operating method of the data analysis device (40) further comprises the process steps of;

    - Gathering the encrypted data by means of the encryption unit (44) in order to transmit (111) the encrypted data in case there is an encryption operation,
- Sending the data directly to the cloud system (50) by means of the encryption unit (44) in case there is no encryption operation.

6. Big data analysis system according to Claim 1, **characterized in that;** it comprises a filtering unit (41) that utilizes Artificial Neural Networks and Multilayer Perceptron algorithms in the filtering and classifying processes of data.

7. Big data analysis system according to Claim 2, **characterized in that;** the algorithm utilized in the process step of executing (104) the filter algorithm by means of the filtering unit (41) performs the process steps of;

- Assigning W and w(0) values randomly,
- Calculating W_gradient and w(0)_gradient values,
- Updating W and w(0) values,
- Returning to the step of calculating W_gradient and w(0)_gradient values if the error margin is above a specific value.

8. Big data analysis system according to Claim 2 or Claim 7, **characterized in that;** the calculation in the process step of calculating W_gradient and w(0)_gradient is performed by using the following equation;

$$Y = W^*X + w(0)$$

9. Big data analysis system according to Claim 2 or Claim 6, **characterized in that;** it comprises a filtering unit (41) that uses a Multilayer Perceptron model consisting of X (input layer), Z (intermediate layer), and Y (output layer).

**FIGURE 1**

**FIGURE 2**

40

41

42

43

44

FIGURE 3

Europäisches
Patentamt
European
Patent Office
Office européen
des brevets

## EUROPEAN SEARCH REPORT

Application Number

EP 20 20 7575

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HUANG YUTAO ET AL: "When deep learning meets edge computing", 2017 IEEE 25TH INTERNATIONAL CONFERENCE ON NETWORK PROTOCOLS (ICNP), IEEE, 10 October 2017 (2017-10-10), pages 1-2, XP033262232, DOI: 10.1109/ICNP.2017.8117585 [retrieved on 2017-11-21] * the whole document * | 1-9 | INV. G06F16/9035 G06N20/00 |
| X | LI HE ET AL: "Learning IoT in Edge: Deep Learning for the Internet of Things with Edge Computing", IEEE NETWORK, IEEE SERVICE CENTER, NEW YORK, NY, US, vol. 32, no. 1, 2018, pages 96-101, XP011676330, ISSN: 0890-8044, DOI: 10.1109/MNET.2018.1700202 [retrieved on 2018-01-25] * section "Introduction", paragraph 2 * * section "Deep learning for IoT in edge computing"; figure 2 * | 1-9 | |

TECHNICAL FIELDS
SEARCHED (IPC)

G06F
G06N
G06K

The present search report has been drawn up for all claims

| Place of search | Date of completion of the search | Examiner |
|---|---|---|
| Berlin | 15 April 2021 | Domingo Vecchioni, M |

EPO FORM 1503 03.82 (P04C01)

**REFERENCES CITED IN THE DESCRIPTION**

**Patent documents cited in the description**

- US 2014336791 A

- KR 101831959